Europäisches Patentamt

European Patent Office

Office européen des brevets

(11) Numéro de publication: **0 275 767**
**A1**

(12) **DEMANDE DE BREVET EUROPEEN**

(21) Numéro de dépôt: **87402914.3**

(22) Date de dépôt: **18.12.87**

(51) Int. Cl.⁴: **G01R 33/02**

(30) Priorité: **23.12.86 FR 8618088**

(43) Date de publication de la demande:
**27.07.88 Bulletin 88/30**

(84) Etats contractants désignés:
**DE GB**

(71) Demandeur: **THOMSON-CSF**
**173, Boulevard Haussmann**
**F-75379 Paris Cédex 08(FR)**

(72) Inventeur: **Guillemin, Germain**
**THOMSON-CSF SCPI 19, avenue de Messine**
**F-75008 Paris(FR)**

(74) Mandataire: **Desperrier, Jean-Louis et al**
**THOMSON-CSF SCPI 19, avenue de Messine**
**F-75008 Paris(FR)**

(54) **Magnétomètre triaxial homocentrique.**

㉗ L'invention concerne un magnétomètre triaxial homocentrique permettant d'obtenir une très bonne homogénéité des mesures selon les trois axes.

Elle consiste à utiliser pour noyau de ce magnétomètre six tores (103) disposés selon les faces d'un cube.

Elle permet de réaliser des magnétomètres dont les caractéristiques sont identiques selon les trois axes de mesure.

# FIG_1

La présente invention concerne un magnétomètre triaxial homocentrique permettant d'obtenir la mesure des trois composantes du champ magnétique en un même point.

La mesure du champ magnétique suivant trois axes rectangulaires en utilisant la technique du noyau saturable, connue le plus souvent sous le nom anglo-saxon de "flux-gate", s'effectue généralement en utilisant trois sondes unidirectionnelles montées sur un support rigide et alignées selon les axes de mesure. Dans un tel cas les trois axes de mesure ne passent pas par un même point, et il reste toujours une certaine influence des sondes entre elles.

Il est connu du brevet anglais 2.044.460 de fabriquer un magnétomètre triaxial homocentrique en utilisant un cylindre creux en matériau magnétique sur lequel est bobiné un enroulement d'excitation toroïdal. Un premier enroulement de mesure est bobiné sur le cylindre avec pour axe celui du cylindre, et deux autres enroulements de mesure sont bobinés toujours sur le cylindre mais selon deux axes perpendiculaires à l'axe du cylindre. Ces enroulements de mesure permettent d'obtenir la valeur des trois composantes perpendiculaires du champ magnétique en un même point situé au centre du cylindre. Il est clair qu'un tel dispositif n'est pas totalement isotrope et que l'homogénéïté des mesures n'est pas la même selon les axes.

L'idéal serait d'avoir un noyau magnétique sphérique, mais on ne saurait plus alors comment l'exciter.

Pour obtenir un magnétomètre triaxial homocentrique le plus symétrique possible, l'invention propose d'utiliser comme noyau magnétique six tores identiques disposés sur les quatre faces d'un cube et comportant chacun leur enroulement d'excitation.

D'autres particularités et avantages de l'invention apparaîtront clairement dans la description suivante présentée à titre d'exemple non limitatif en face des figures annexées qui représentent :

- la figure 1 : un cube supportant des tores formant le noyau d'un magnétomètre selon l'invention ;

- La figure 2 : le schéma des bobinages de mesure ou de détection d'un tel magnétomètre ;

- la figure 3 : une coupe d'un corps formant la structure de ce magnétomètre ;

- la figure 4 : une vue de dessus de ce corps.

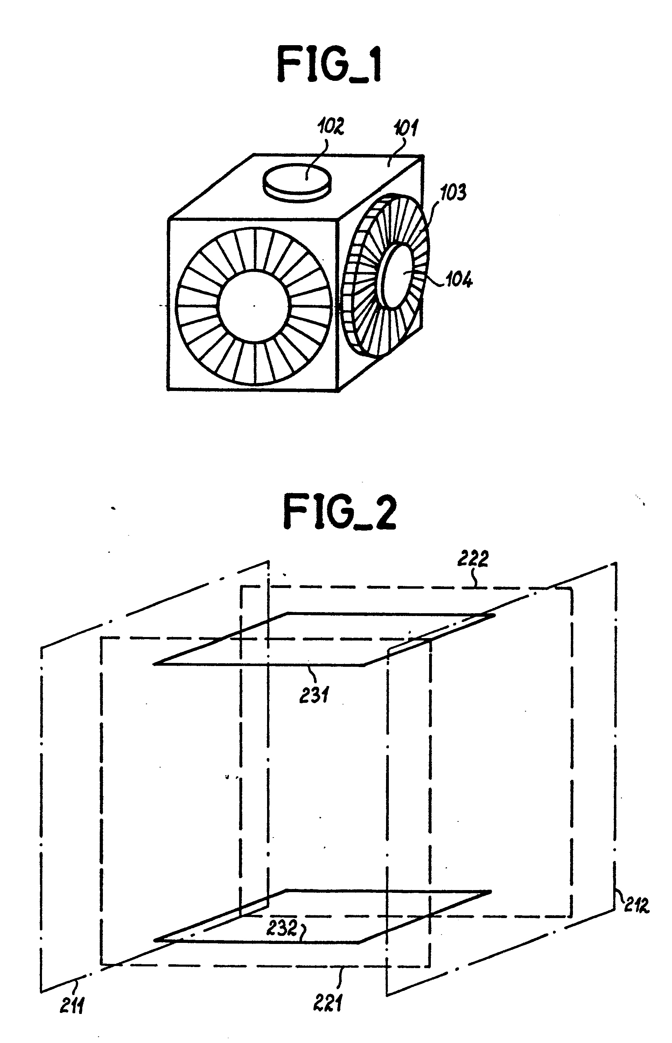

On a représenté sur la figure 1 un cube 101, par exemple en plastique, destiné à supporter les six tores formant le noyau du magnétomètre. Sur chacune des six faces du cube on trouve un bossage cylindrique 102 de faible hauteur obtenu par exemple par fraisage de la face. Ce cylindre est situé au centre de la face et sert de centreur au tore 103 formant un des éléments actifs du noyau du magnétomètre. Ces tores ont la forme de rondelles très plates, découpées par exemple dans un ruban de matériau amorphe, et sont rigoureusement identiques entre eux. On a bobiné de manière toroïdale sur chacun de ces tores un bobinage 104 permettant, à l'aide de fils d'alimentation non représentés, de soumettre les tores à un champ magnétique alternatif qui les porte à saturation selon le principe connu de ce genre de magnétomètre. Ces bobinages sont bien entendu identiques entre eux. Le tore de la face supérieure n'a pas été représenté de facon à mieux montrer le centreur 102.

Une telle configuration permet d'obtenir une symétrie très satisfaisante du noyau magnétique. Pour obtenir une caractérisque homocentrique la meilleure possible on prend pour diamètre extérieur des tores une valeur très légèrement inférieure à la longueur de l'arête des cubes, de manière à laisser juste la place pour le bobinage sans avoir d'intervalle à l'endroit où les bords des tores se rapprochent le plus. On peut par exemple utiliser des tores de diamètre extérieur 20mm et de diamètre intérieur 10mm.

Le cube 101 est situé au centre d'un ensemble de bobinages tel que représenté sur la figure 2. Sur cette figure ces bobinages sont de forme carrée mais cette forme pourrait être par exemple octogonale ou même circulaire.

Il y a un jeu de bobinages par direction, c'est-à-dire trois jeux pour les trois directions perpendiculaires selon lesquelles on veut mesurer les composantes du champ magnétique. Chaque jeu de bobinages est symétrique par rapport au centre du dispositif, c'est-à-dire par rapport au centre du cube 101. Dans le cas de figure il y a par jeu de bobinages deux bobines situées d'un côté et de l'autre de ce centre. C'est ainsi que l'on a les bobines 211 et 212 (trait mixte) pour une direction, 221 et 222 (trait pointillé) pour une autre direction, et 231 et 232 (trait plein) pour la troisième direction.

Pour la clarté du dessin les bobines ont été représentées sur la figure 2 avec des dimensions nettement différentes les unes des autres, mais dans les réalisations pratiques on limitera ces différences à une valeur juste nécessaire pour permettre l'imbrication des bobines les unes dans les autres.

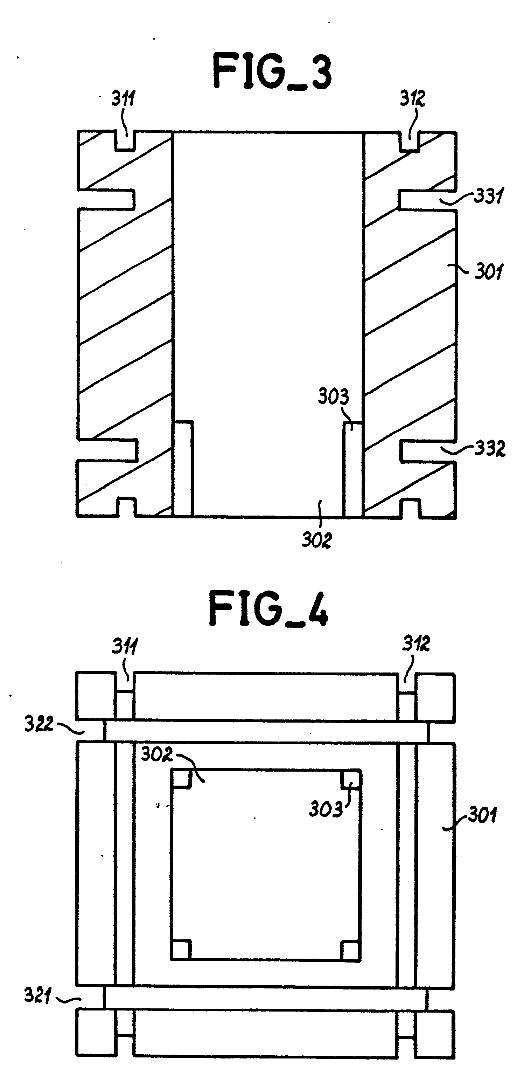

On a représenté sur les figures 3 et 4 une pièce permettant de maintenir les bobinages de la figure 2 ainsi que le cube 101 de la figure 1.

Cette pièce est formée d'un corps 301 de forme extérieurement cubique, percé de part en part d'une ouverture 302 formant un parallélépipède rectangle. Lors de l'usinage de cette ouverture on a laissé subsister des épaulements 303 en forme de colonnettes situées dans les coins de l'ouverture. De cette manière en introduisant le cube 101 dans l'ouverture 302 par l'extrémité opposée à ces excroissances, celui-ci glisse à frottement doux dans l'ouverture et vient s'arrêter en butée sur les épaulements 303 dont la taille et l'emplacement sont prévus pour que le cube 101 soit maintenu en position centrale dans la pièce 301. Les épaulements 303 viennent s'appuyer sur les coins de l'une des faces du cube 101 dans l'espace libre subsistant au-delà de celui des tores qui occupent cette face.

On bloque ensuite le cube 101 dans cette position à l'aide d'une pièce quelconque, par exemple un cavalier qui vient entrer par force dans le corps en s'appuyant sur deux arêtes du cube opposées à l'ouverture 302.

Les faces de la pièce 301 sont usinées pour présenter trois ensembles de rainures 311-312, 321-322, et 331-332 correspondant respectivement aux ensembles de bobines 211-212, 221-222 et 231-232.

Les proportions des figures 3 et 4 relativement à la profondeur des rainures sont plus proches de la réalité que celles des dimensions des bobines sur la figure 2 et l'on remarque que les rainures les plus profondes, correspondant au bobines les plus petites, sont les plus rapprochées les unes des autres afin de maintenir l'homogénéité du champ de mesure.

Ce dispositif permet de maintenir avec une grande rigidité les bobines de mesure et donc de minimiser au maximum les irrégularités et les variations du positionnement de ces bobines et donc celles de la mesure.

L'utilisation de deux bobines par jeu de bobinages, correspondant à la disposition de Helmhotz, peut être améliorée en multipliant le nombre des bobines pour augmenter l'homogénéité du champ. Quand on a obtenu par le calcul, de manière classique, le nombre, le dimensionnement et la répartition des bobines pour obtenir la précision souhaitée, on usine alors les rainures nécessaires dans la pièce 301 pour placer ces bobines.

## Revendications

1. Magnétomètre triaxial homocentrique, du type comprenant un noyau muni d'un enroulement d'excitation et trois bobinages de détection entourant ce noyau et orientés respectivement selon les axes d'un trièdre trirectangle, caractérisé en ce que le noyau est composé de six tores magnétiques identiques (103) disposés selon les faces d'un cube (101) et munis chacun d'un enroulement d'excitation identique.

2. Magnétomètre selon la revendication 1, caractérisé en ce que les tores (103) sont orientés par deux selon les axes du trièdre trirectangle.

3. Magnétomètre selon l'une quelconque des revendications 1 et 2, caractérisé en ce que les tores (103) ont la forme de rondelles plates.

4. Magnétomètre selon la revendication 3, caractérisé en ce que les tores sont en matériau magnétique amorphe.

5. Magnétomètre selon l'une quelconque des revendications 1 à 4, caractérisé en ce que les tores (103) sont supportés par un cube (101) en matériau non magnétique dont les faces comportent des bossages (102) de centrage permettant de maintenir les tores, et dont les dimensions sont telles que chaque tore est adjacent à quatre autres tores.

6. Magnétomètre selon la revendication 5, caractérisé en ce qu'il comprend en outre une pièce de forme cubique (301) munie d'une cavité centrale (302) débouchant sur au moins une face de cette pièce et dans laquelle est inséré le cube (201) support des tores (103), de manière à ce que le centre du cube coïncide avec le centre de la pièce, cette pièce étant munie sur ses faces de rainures (311-332) dans lesquelles sont immobilisées les bobines (211-232) des bobinages de détection.

# FIG_1

102  101

103

104

# FIG_2

222

231

232

211  221  212

## FIG_3

## FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 154 129 (F. FORSTER PRÜFGERÄTEBAU GmbH) * Résumé; figures 1,2 * | 1-3 | G 01 R 33/02 |
| Y | TRANSACTIONS US INSTITUTE OF ELECTRICAL ENGINEERING, COMMUNICATION AND ELECTRONICS, vol. 59, partie 1, mars 1962, pages 65-73, New York, US; W.A. GEYGER: "The ring-core magnetometer - A new type of second-harmonic flux-gate magnetometer" * Page 65, colonne 1, ligne 1 - colonne 3, ligne 7; figures 1b,2c; page 72: "Conclusions" * | 1-3 | |
| A | US-A-4 293 815 (J.B. WEST et al.) * Colonne 7, lignes 31-44; figure 5 * | 2,3 | |
| A | PATENT ABSTRACTS OF JAPAN, vol. 9, no. 182 (P-376)[1905], 27 juillet 1985; & JP-A-60 53 861 (WAKOMU K.K.) 27-03-1985 | | |
| A | US-A-3 800 213 (L.H. RORDEN) | | |

DOMAINES TECHNIQUES RECHERCHES (Int. Cl.4)

G 01 R

Le présent rapport a été établi pour toutes les revendications

| Lieu de la recherche | Date d'achèvement de la recherche | Examinateur |
|---|---|---|
| LA HAYE | 31-03-1988 | HAASBROEK J.N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................
& : membre de la même famille, document correspondant

EPO FORM 1503 03.82 (P0402)